Europäisches Patentamt

European Patent Office

Office européen des brevets

(11) Veröffentlichungsnummer: **0 204 894 B1**

## EUROPÄISCHE PATENTSCHRIFT

(45) Veröffentlichungstag der Patentschrift: **28.08.91**

(51) Int. Cl.⁵: **H03L 7/00**

(21) Anmeldenummer: **86103120.1**

(22) Anmeldetag: **08.03.86**

(54) Taktregenerator.

(30) Priorität: **10.06.85 CH 2440/85**

(43) Veröffentlichungstag der Anmeldung:
**17.12.86 Patentblatt 86/51**

(45) Bekanntmachung des Hinweises auf die
Patenterteilung:
**28.08.91 Patentblatt 91/35**

(84) Benannte Vertragsstaaten:
**AT BE CH DE FR GB IT LI NL SE**

(56) Entgegenhaltungen:
**DE-A- 2 720 747**
**US-A- 4 227 251**
**US-A- 4 280 099**
**US-A- 4 400 817**

**IEEE TRANSACTIONS ON COMMUNICA-
TIONS, Band COM-32, Nr. 12, Dezember 1984,
Seiten 1269-1276, IEEE, New York, US; J.-P.
SANDOZ et al.: "Performance improvement
of a binary quantized all-digital phase-locked
loop with a new aided-acquisition technique"**

**IEEE TRANSACTIONS ON COMMUNICA-
TIONS, Band COM-20, Nr. 2, April 1972, Seiten 94-104, New York, US; J.R. CESSNA et al.:**

**"Phase noise and transient times for a binary quantized digital phase-locked loop in
white Gaussian noise"**

(73) Patentinhaber: **SIEMENS-ALBIS AKTIENGE-
SELLSCHAFT**
**PV/Patente und Verträge Postfach**
**CH-8047 Zürich(CH)**

(84) Benannte Vertragsstaaten:
**CH LI**

Patentinhaber: **Siemens Aktiengesellschaft**
**Wittelsbacherplatz 2**
**W-8000 München 2(DE)**

(84) Benannte Vertragsstaaten:
**BE DE FR GB IT NL SE AT**

(72) Erfinder: **Wenger, Bruno**
**Aubrigstrasse 5**
**CH-8804 Au / ZH(CH)**

## EP 0 204 894 B1

**Beschreibung**

Die vorliegende Erfindung betrifft einen Taktregenerator nach dem Oberbegriff des Patentanspruches 1.

In der digitalen Nachrichtentechnik werden oft neben passiven Taktregeneratoren oder Taktextrahierern auch aktive Taktregeneratoren eingesetzt, die mit einem zusätzlichen Oszillatorsignal arbeiten. Für das Problem, einerseits eine gute Unterdrückung des Signaljitters und andererseits eine schwélle Synchronisation von Eingangssignal und erzeugtem Signal zu gewährleisten, finden sich in IEEE TRANSACTIONS ON COMMUNICATIONS, Band COM-32, Nr. 12, Dezember 1984, Seiten 1269-1276, IEEE, New York, US; J. -P. SANDOZ et al.: "Performance improvement of a binary quantized all-digital phase-locked loop with a new aided-acquisition technique", und in US-A-4 280 099 beispielhaft Lösungen.

Durch die vorliegende Erfindung soll eine spezielle Lösung für einen aktiven Taktregenerator angegeben werden, der relativ schnell arbeitet und eine besonders gute Jitterverträglichkeit aufweist.

Dies wird erfindungsgemäss durch die im kennzeichnenden Teil des Anspruches 1 angegebenen Massnahmen erreicht. Vorteilhafte Ausgestaltungen der Erfindung sind in den abhängigen Ansprüchen angegeben.

Die Erfindung wird nachfolgend durch Beschreibung Von Ausführungsbeispielen anhand von Zeichnungen näher erläutert. Es zeigt:

Fig. 1    das Schaltbild eines Taktregenerators nach der Erfindung,

Fig. 2    das Schaltbild eines Schleifenfilters zu einem solchen Taktregenerator,

Fig. 3    ein Zeitdiagramm für verschiedene Signale,

Fig. 4    das Schaltbild eines Phasendetektors zu einem solchen Taktregenerator.

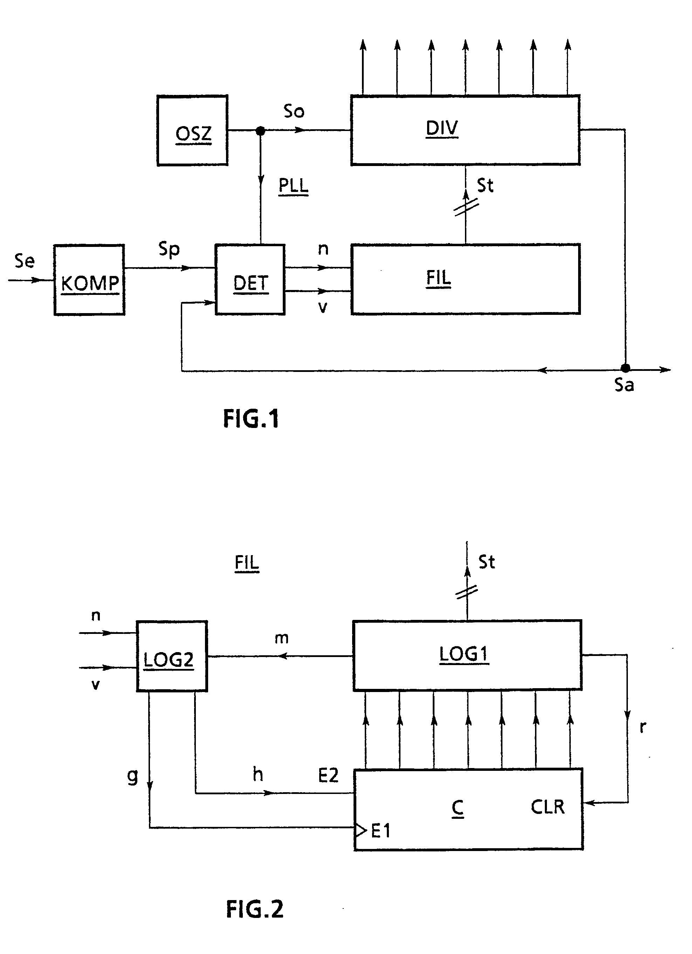

Der Taktregenerator nach Fig. 1 umfasst einen mit dem Ausgang eines Oszillators OSZ verbundenen programmierbaren Teiler DIV, dessen Ausgangssignal Sa eine Frequenz fa aufweist, die ungefähr um den Faktor N kleiner als die Frequenz fo des Oszillatorsignals So ist. Der Taktregenerator umfasst zudem eine Komparatorschaltung KOMP, die ein empfangenes Augensignal Se in Impulse Sp umwandelt, sowie einen Phasendetektor DET und ein Schleifenfilter FIL, dessen Ausgangssignal St den Teiler DIV steuert. Der Phasendetektor DET vergleicht die Signale Sp und Sa mit Hilfe des Signals So und gibt zwei Signale n und v ab, mit denen das Schleifenfilter gesteuert wird.

Der Taktregenerator nach Fig. 1 ist grundsätzlich wie ein Phasenregelkreis oder eine PLL-Schaltung (Phase-Locked Loop) aufgebaut, so dass seine prinzipielle Arbeitsweise bekannt ist.

Das Schleifenfilter nach Fig. 2 weist einen Zähler C und zwei Logikschaltungen LOG1 und LOG2 auf, von denen die zweite die Signalen n und v empfängt und die erste das Steuersignal St sowie ein Meldesignal m zur Steuerung der Schaltung LOG2 und ein Rückstellsignal r für den Zähler C abgibt. Die Schaltung LOG1 ist eingangsseitig an die verschiedenen Ausgänge des Zählers C angeschlossen, dessen Takteingang E1 mit einem ersten Ausgangssignal g und dessen Zählrichtungseingang E2 mit einem zweiten Ausgangssignal h der Schaltung LOG2 beaufschlagt ist.

Der Taktregenerator nach Fig. 1 und 2 funktioniert folgendermassen:

Der programmierbare Teiler DIV teilt normalerweise die Frequenz fo $\simeq$ N$\cdot$fa des Oszillators OSZ (Fig. 1) durch N, um ein Taktsignal Sa zu erhalten, das etwa die gleiche Frequenz fa$\simeq$fe wie das ankommende Signal Se aufweist. Der Phasendetektor DET vergleicht die Phasenlage der synthetisierten Impulse Sa mit derjenigen der am Ausgang der Schaltung KOMP gewonnenen Impulse Sp und prüft, wie weit die Flanken des Signals Sa vor oder nach den Flanken des Signals Sp ankommen.

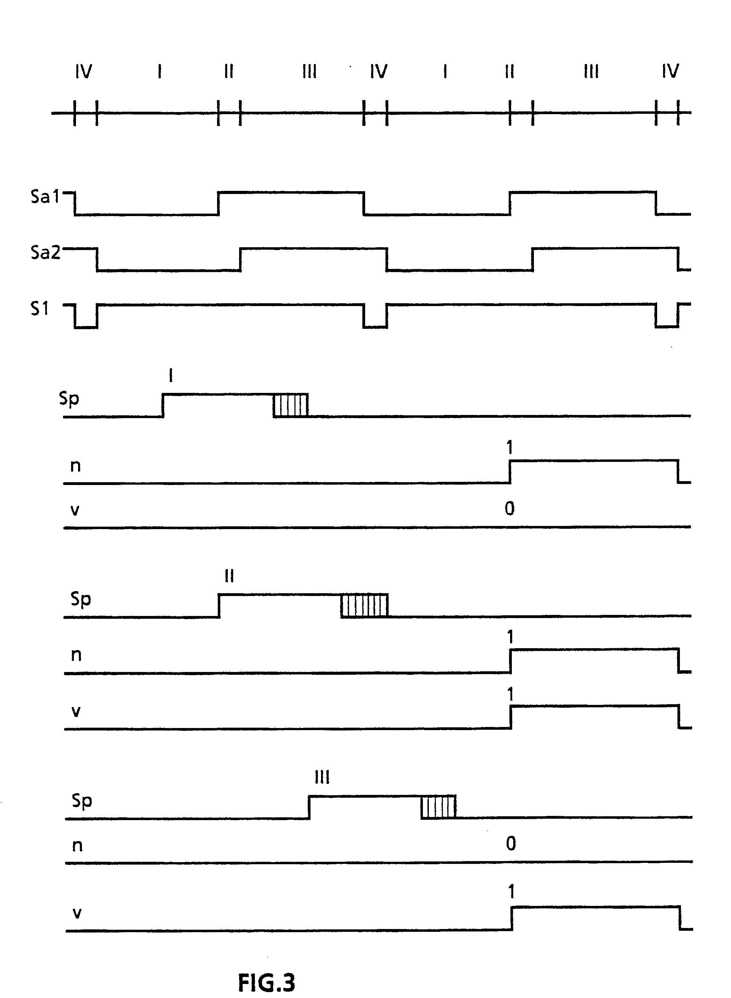

Zu diesem Zweck erfährt der Takt Sa im Phasendetektor DET eine Verzögerung beliebiger Dauer, die auch Null sein kann. Der resultierende Takt Sa 1 (Fig. 3) wird dann noch derart verzögert, dass ein um L/N Perioden gegenüber dem Takt Sa1 verzögerter Takt Sa2 entsteht, worin L eine kleine ganze Zahl, vorzugsweise L = 1, ist. Dadurch entsteht das in Fig. 3 dargestellte Impulsfenster mit vier Bereichen I, II, III und IV, wie folgt:

| | | | |
|---|---|---|---|
| Bereich I : | Sa 1 = 0 | und | Sa2 = 0 |
| Bereich II : | Sa 1 = 1 | und | Sa2 = 0 |
| Bereich III : | Sa 1 = 1 | und | Sa2 = 1 |
| Bereich IV: | Sa 1 = 0 | und | Sa2 = 1 |

Jedesmal, wenn eine ansteigende Flanke des Signals Sp ankommt, das verjittert sein kann, werden Impulse n und v erzeugt, und zwar je nachdem in welchem der Bereiche I, II, III oder IV die Flanke liegt gemäss

2

folgender

Vorschrift I:

Bereich I : $n = 1$ und $v = 0$

Bereich II : $n = 1$ und $v = 1$

Bereich III: $n = 0$ und $v = 1$

Bereich IV: $n = 0$ und $v = 0$

Dabei bedeutet $n = 0$ bzw. $v = 0$, dass momentan kein Impuls, und $n = 1$ bzw. $v = 1$, dass momentan ein beispielsweise halbbitbreiter Impuls vorhanden ist. Aus den Impulsen n, v und m werden durch die Schaltung LOG2 der Taktimpuls g sowie das zur Steuerung der Zählrichtung dienende Signal h erzeugt. Der Zählerstand des Zäh-lers C wird von der Schaltung LOG1 erkannt, so dass beispielsweise bei einem positiven Zählerstand das Signal m den Wert $m = 1$ hat.

Der Zähler C beginnt bei einem Wert 0 zu zählen und zählt nach folgender

Vorschrift II:

Mit jedem Impuls $v = 1$ zählt der Zähler C um einen Wert X in positiv er Richtung, beispielsweise von $+6$ auf $+7$ oder von -3 auf -2 mit $X = 1$. Mit jedem Impuls $n = 1$ zählt der Zähler um einen Wert X in negativ er Richtung, beispielsweise von -6 auf -7 oder von $+3$ auf $+2$ mit $X = 1$. Wenn gleichzeitig $v = 1$ und $n = 1$ ist, zählt der Zähler um einen Wert Y gegen Null, beispielsweise von $+6$ auf $+5$ mit $Y = 1$ bei $m = 1$ oder von -6 auf -5 bei $m = 0$. Wenn keine Flanke kommt, ist gleichzeitig $v = 0$ und $n = 0$ und der Zähler zählt nicht.

Solange der Zählerstand einen Wert $+K$ oder -K nicht erreicht hat, enthält das Steuersignal St die Information, dass der Teiler DIV (Fig. 1) durch N teilen soll. Erreicht der Zählerstand den Wert $+K$, so bewirkt das Steuersignal St, dass der Teiler DIV durch (N + 1) statt durch H teilt, wodurch die Frequenz fa des Taktes Sa kleiner wird; erreicht aber der Zählerstand den Wert -K, so bewirkt das Steuersignal St, dass der Teiler DIV durch (N - 1) statt durch N teilt, wodurch die Frequenz fa des Taktes Sa grösser wird. In den beiden letzten Fällen wird jedoch zugleich eine Aenderung des Signals r veranlasst, durch die der Zähler C (Fig. 2) auf Null gesetzt wird.

Der erfindungsgemässe Taktregenerator bewirkt ein rasches Korrigieren der Phasendifferenz, wenn die Takte Sa und Sp nicht in Phase sind, und verhindert gleichzeitig unnötige und störende Korrekturen, wenn die Takte Sa und Sp in Phase sind. Zudem arbeitet der Taktregenerator auch zufriedenstellend, wenn der Takt Sp verjittert ist.

Wenn alle verjitterten Impulsflanken in den Bereich II fallen, das heisst, wenn $n = 1$ und $v = 1$ ist, zählt der Zähler C gegen Null, und es wird keine Korrektur bewirkt. Wenn es mehr Impulse im Bereich III (mit n = 0 und $v = 1$) als im Bereich II (mit $n = 1$ und $v = 1$) gibt, nähert sich der Zählerstand um so schneller dem Schwellenwert $+K$, je grösser der Anteil der Impulse ist, die im Bereich III liegen. Wenn es mehr Impulse im Bereich I (mit $n = 1$ und $v = 0$) als im Bereich II gibt, nähert sich der Zählerstand um so schneller dem Schwellenwert -K, je grösser der Anteil der Impulse ist, die im Bereich I liegen. Gibt es nur Impulse im Bereich III, so steigt der Zählerstand sofort auf den Schwellenwert $+K$; gibt es nur Impulse im Bereich I, zählt er sofort bis zum Schwellenwert -K.

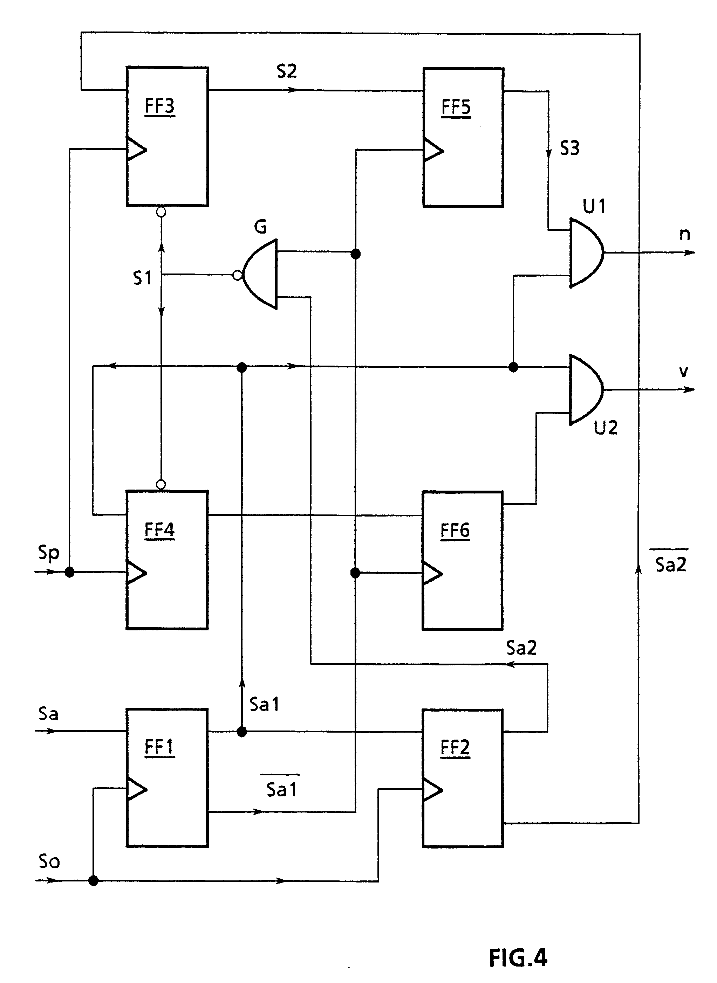

Der in Fig. 4 dargestellte Phasendetektor umfasst zwei Kippschaltungen FF1 und FF2, die für die Verzögerung des Impulses Sa2 verantwortlich sind, sowie vier weitere Kippschaltungen FF3, FF4, FF5 und FF6, ein Nicht-UND-Tor G und zwei UND-Tore U1 und U2, die zur Realisierung der Vorschrift I dienen. In Fig. 3 sind die Impulse n und v dargestellt, die sich für den Fall ergeben, dass die Flanke des Signals Sp in den Bereich I, II bzw. III fällt. Für den Bereich IV gilt bei einem Detektor gemäss Fig. 4 $n = 0$ und $v = 0$. Da der Bereich IV irrelevant ist, können auch andere Detektoren eingesetzt werden, bei denen $n = 0$, $v = 1$ oder $n = 1$, $v = 0$ ist.

Schliesslich sei noch bemerkt, dass bei jeder Korrektur der Takt Sa beispielsweise um 1/N Periode in der Phase nachgestellt wird, dann aber immer wieder umso schneller davonläuft, je grösser die Abweichung zwischen den Frequenzen fe und fo/N ist. Somit ist der Takt Sa mit einem systematischen Jitter der Grösse 1/N Periode behaftet. Das erfindungsgemässe Verfahren erweist sich jedoch als vorteilhaft, weil

3

EP 0 204 894 B1

ohne die zwei Takte Sa1 und Sa2 sich ein systematischer Jitter der Grösse 2/N statt 1/N Periode ergeben würde.

In weiterer Ausgestaltung der Erfindung kann der Zähler C derart beschaffen sein, dass er mit grösseren Schritten als X = 1 zählt, wenn der Zählerstand näher bei einem der Schwellenwerte +K bzw. -K liegt. Zu diesem Zweck kann man beispielsweise auch fünf, sieben oder mehr Bereiche vorsehen. Zudem kann der Teiler DIV eine Mehrzahl von Signalen mit je einer Frequenz fa, 2fa, 4fa, ..... und/oder (i/j) fa, z.B. (6/5) fa, abgeben.

**Patentansprüche**

1. Taktregenerator mit einem Zähler (C) zur Jitterausfilterung und mit einem Phasendetektor (DET), in dem die Phasenlage des Eingangssignals (Sp), dessen Frequenz zu regenerieren ist, mit derjenigen des Ausgangssignals (Sa) des als Phasenregelkreis (PLL) ausgebildeten Taktregenerators verglichen wird, dessen Oszillatorfrequenz angenähert N-mal grösser als die regenerierte Frequenz ist, **dadurch gekennzeichnet,** dass im Phasendetektor (DET) aus dem regenerierten Signal (Sa) mindestens ein um L/N Perioden verzögertes Signal (Sa1, Sa2) gewonnen wird, worin L eine kleine ganze Zahl ist, um daraus ein Impulsfenster mit mindestens drei Bereichen (I, II, III) zu bilden, wobei die Ausgangssignale (n, v) des Phasendetektors (DET) jeweils angeben, in welchem Bereich sich die Flanke des Eingangssignals (Sp) befindet, und dass der Taktregenerator einen programmierbaren Teiler (DIV) sowie ein Schleifenfilter (FIL) mit dem Zähler (C) aufweist, dessen Zählerstand in einer Logikschaltung (LOG1) registriert wird, die den Teiler (DIV) derart steuert, dass, wenn die Flanken der Eingangsimpulse (Sp) in den mittleren Bereich (II) fallen, der Zähler (C) gegen Null zählt und keine Korrektur bewirkt wird.

2. Taktregenerator nach Anspruch 1, **dadurch gekennzeichnet,** dass, wenn durchschnittlich mehr Impulsflanken (Sp) im ersten als Im mittleren Bereich ankommen, der Zähler (C) zu einem negativen Schwellenwert (-K) hin zählt und, wenn dieser erreicht wird, der Teiler (DIV) durch N-1 teilt und der Zählerstand auf Null rückgestellt wird, und dass, wenn durchschnittlich mehr Impulsflanken (Sp) im dritten als im mittleren Bereich ankommen, der Zähler (C) zu einem positiven Schwellenwert (+K) hin zählt und, wenn dieser erreicht wird, der Teiler (DIV) durch N+1 teilt und der Zählerstand auf Null rückgestellt wird.

3. Taktregenerator nach Anspruch 1 oder 2, **dadurch gekennzeichnet,** dass das Schleifenfilter (FIL) eine weitere Logikschaltung (LOG2) aufweist, die eingangsseitig mit den Ausgangssignalen (v, n) des Phasendetektors (DET) beaufschlagt ist, und dass die erste Logikschaltung (LOG1) ein Meldesignal (m) abgibt, das der weiteren Logikschaltung (LOG2) zugeführt wird, um das Vorzeichen des Zählerstandes anzugeben.

4. Taktregenerator nach Anspruch 3, **dadurch gekennzeichnet,** dass die erste Logikschaltung (LOG1) ein Rückstellsignal (r) abgibt, um den Zähler (C) nach Erreichen eines der beiden Schwellenwerte (+K, -K) auf Null zurückzustellen.

**Claims**

1. A clock regenerator having a counter (C) for filtering-out jitter and having a phase detector (DET) in which the phase angle of the input signal (Sp), the frequency of which is to be regenerated, is compared with that of the output signal (Sa) of the clock regenerator, the clock regenerator being formed as a phase-locked loop (PLL) and having an oscillator frequency that is approaching N-times greater than the regenerated frequency,
characterised in that in the phase detector (DET) at least one signal (Sa1, Sa2), delayed by L/N periods, is derived from the regenerated signal (Sa), where L is a small whole number, in order to form a pulse window therefrom with at least three ranges (I,II,III), the output signals (n,v) of the phase detector (DET) respectively indicating in which range the edge of the input signal (Sp) is located, and in that the clock regenerator has a programmable divider (DIV), as well as a loop filter (FIL) including the counter (C), the counter reading of which is registered in a logic circuit (LOG1) which controls the divider (DIV) such that if the edges of the input pulses (Sp) fall within the middle range (II), the counter (C) counts towards zero and no correction is effected.

2. A clock regenerator according to claim 1, characterised in that if on average more pulse edges (Sp)

4

EP 0 204 894 B1

arrive in the first range than in the middle range, the counter (C) counts towards a negative threshold value (-K) and, if this value is attained, the divider (DIV) divides by N-1 and the counter reading is reset to zero, and in that if on average more pulse edges (Sp) arrive in the third range than in the middle range, the counter (C) counts towards a positive threshold value (+K) and, if this value is attained, the divider (DIV) divides by N+I and the counter reading is reset to zero.

3. A clock regenerator according to claim 1 or 2, characterised in that the loop filter (FIL) has a further logic circuit (LOG2), which receives at its input side the output signals (v,n) of the phase detector (DET), and in that the first logic circuit (LOG1) delivers an indicating signal (m), which is supplied to the further logic circuit (LOG2), in order to indicate the sign of the counter reading.

4. A clock regenerator according to claim 3, characterised in that the first logic circuit (LOG1) delivers a reset signal (r), in order to reset the counter (C) to zero after one of the two threshold values (+K,-K) is attained.

**Revendications**

1. Régénérateur de cadence comportant un compteur (C) servant à éliminer par filtrage les instabilités, et un détecteur de phase (DET), dans lequel la position de phase du signal d'entrée (Sp), dont la fréquence doit être régénérée, est comparée à celle du signal de sortie (Sa) du régénérateur de cadence qui est réalisé sous la forme d'un circuit de régulation de phase (PLL) et dont la fréquence de l'oscillateur est approximativement N fois supérieure à la fréquence régénérée, caractérisé par le fait qu'au moins un signal (Sa1,Sa2) retardé de L/N périodes, L étant un nombre entier faible, est obtenu dans le détecteur de phase (DET) à partir du signal régénéré (Sa), pour la formation, à partir dudit signal, d'une fenêtre de transmission d'impulsions comportant au moins trois zones (I,II,III), les signaux de sortie (n,v) du détecteur de phase (DET) indiquant respectivement dans quelle zone est situé le flanc du signal d'entrée (Sp), et que le régénérateur de cadence possède une diviseur programmable (DIV) ainsi qu'un filtre en boucle (FIL) équipé du compteur (C), dont l'état de comptage est enregistré dans le circuit logique (LOG1), qui commande le diviseur (DIV) de telle sorte que, lorsque les flancs des impulsions d'entrée (Sp) arrivent dans la zone médiane (II), le compteur (C) effectue un comptage vers zéro et qu'aucune correction n'est exécutée.

2. Régénérateur de cadence suivant la revendication 1, caractérisé par le fait que, lorsqu'il arrive en moyenne un plus grand nombre de flancs d'impulsions (Sp) dans la première zone que dans la zone médiane, le compteur (C) compte jusqu'à une valeur de seuil négative (-K) et que, lorsque cette valeur de seuil est atteinte, le diviseur (DIV) réalise une division par N-1 et l'état de comptage est ramené à zéro, et que, lorsqu'il apparaît en moyenne un plus grand nombre de flancs d'impulsions (Sp) dans la troisième zone que dans la zone médiane, le compteur (C) compte jusqu'à une valeur de seuil positive (+K) et que, lorsque cette valeur de seuil est atteinte, le diviseur (DIV) effectue une division par N+1 et l'état du compteur est ramené à zéro.

3. Régénérateur de cadence suivant la revendication 1 ou 2, caractérisé par le fait que le filtre en boucle (FIL) comporte un autre circuit logique (LOG2), qui est chargé, côté entrée, par les signaux de sortie (v,n) du détecteur de phase (DET), et que le premier circuit logique (LOG1) délivre un signal de signalisation (m), qui est envoyé à l'autre circuit logique (LOG2) pour indiquer le signe de l'état du compteur.

4. Régénérateur de cadence suivant la revendication 3, caractérisé par le fait que le premier circuit logique (LOG1) délivre un signal de remise à zéro (r) pour ramener à zéro le compteur (C) dès que l'une des deux valeurs de seuil (+K,-K) est atteinte.

5

FIG.1

FIG.2

**FIG.3**

**FIG.4**